# EUROPEAN PATENT APPLICATION

(11) **EP 4 811 425 A1**
(43) Date of publication of application: **23.09.2026**
(21) Application number: 24906091.4
(22) Date of filing: 04.12.2024
(51) Int. Cl.: H01L 21/687, H01L 21/67

(54) **SEMICONDUCTOR PROCESS CHAMBER AND LIFTING MECHANISM THEREFOR**

(30) Priority: 18.12.2023 CN 202311747932
(71) Applicant: Beijing NAURA Microelectronics Equipment Co., Ltd., Beijing 100176 (CN)
(72) Inventor: LI, Xue, Beijing 100176 (CN); LIU, Pengliang, Beijing 100176 (CN); XU, Shang, Beijing 100176 (CN)
(74) Representative: Cohausz & Florack
(86) International application number: PCT/CN2024/136655
(87) International publication number: WO 2025/130607

(57) **Abstract**

The present disclosure provides a semiconductor process chamber and a lifting mechanism thereof, and belongs to the technical field of semiconductor processing. The disclosed lifting mechanism includes a lift pin assembly, a first drive source, and a second drive source. The first drive source is connected to the lift pin assembly, the second drive source is configured to be connected to a chamber body of the semiconductor process chamber, and a telescopic end of the second drive source is connected to the first drive source, the second drive source drives the first drive source to be lifted or lowered among positions of different heights, and the first drive source is configured to drive the lift pin assembly at positions of different heights, such that the lift pin assembly is lifted or lowered among a plurality of process positions. The above solution can solve the problem that the lifting mechanism has relatively great difficulty in adjusting a process position of a wafer.

## Description

### TECHNICAL FIELD

The present disclosure belongs to the technical field of semiconductor processing, and specifically relates to a semiconductor process chamber and a lifting mechanism thereof.

### BACKGROUND

At present, the application range of semiconductor devices is becoming increasingly wide, and improving the production yield of semiconductor devices has become one of the important production objectives of semiconductor devices, which has imposed higher requirements on the fabrication processes of semiconductor devices and semiconductor process equipment for fabricating semiconductor devices.

The semiconductor process equipment mainly includes a process chamber, a wafer carrier, and a lifting mechanism, where the wafer carrier is disposed in the process chamber, a wafer for fabricating semiconductor devices can be placed on the wafer carrier, and the lifting mechanism is connected to the wafer carrier. During use, one end of the lifting mechanism can pass through the wafer carrier and apply a force to the wafer, such that the wafer is lifted or lowered to change the position of the wafer in the process chamber, thereby matching process requirements.

During the wafer processing process, some fabrication processes (for example, a photoresist stripping process) include a plurality of processes, and under different processes, the process temperatures needed by the wafer are different. Therefore, the lifting mechanism needs to drive the wafer to move up and down to different process positions. At different process positions, the distances between the wafer and the heating device are different, such that the process temperatures that the wafer can reach are also different.

The above lifting mechanism mainly includes a cylinder, where the cylinder is usually provided with three vent ports, and the vent ports are arranged at intervals in the vertical direction. By supplying gas to different vent ports, the telescopic end of the cylinder can be switched among a highest position, an intermediate position, and a lowest position, and the telescopic end can drive the wafer to move up and down, thereby causing the wafer to move up and down to different process positions. However, when the process chamber is in an atmospheric state and the wafer is lowered from the highest position to the lowest position, gas needs to be simultaneously supplied to the top vent port and the middle vent port of the cylinder. At this time, the gas pressure inside the cylinder is balanced, thereby resulting in a condition where the telescopic end cannot extend or retract, and therefore the wafer cannot be driven to be lifted or lowered. Thus, it can be seen that this type of lifting mechanism has relatively great difficulty in adjusting the process position of the wafer.

### SUMMARY

The present disclosure provides a semiconductor process chamber and a lifting mechanism thereof, so as to solve the problem that the lifting mechanism has relatively great difficulty in adjusting a process position of a wafer.

In order to solve the above technical problem, the present disclosure adopts the following technical solutions:
In a first aspect, an embodiment of the present disclosure provides a lifting mechanism for a semiconductor process chamber, where the lifting mechanism includes a lift pin assembly; a first drive source in driving connection with the lift pin assembly; and a second drive source configured to be connected to a chamber body of the semiconductor process chamber, and a telescopic end of the second drive source is connected to the first drive source, the second drive source drives the first drive source to be lifted or lowered among positions of different heights, and the first drive source is configured to drive the lift pin assembly at positions of different heights, such that the lift pin assembly is lifted or lowered among a plurality of process positions.
In a second aspect, an embodiment of the present disclosure provides a semiconductor process chamber, including a chamber body and the above lifting mechanism, the lifting mechanism being connected to the chamber body.

The technical solutions adopted in the present disclosure can achieve the following beneficial effects:
In the present disclosure, the second drive source can drive the first drive source to be lifted or lowered among positions of different heights. Therefore, through the combination of the first drive source and the second drive source, the lift pin assembly can be lifted or lowered among a plurality of process positions, thereby adjusting the process position of the wafer. Thus, it can be seen that, in the present disclosure, the plurality of process positions of the wafer are assigned to the first drive source and the second drive source, that is, lifting or lowering of the wafer among the plurality of process positions is achieved through the combination of the first drive source and the second drive source, such that the respective positions needed to be reached by the first drive source and the second drive source are reduced, and therefore a condition in which the wafer cannot be lifted or lowered due to gas pressure balance is less likely to occur. Therefore, the technical solutions disclosed in the present disclosure can solve the problem that the lifting mechanism has relatively great difficulty in adjusting the process position of the wafer.

### BRIEF DESCRIPTION OF THE DRAWINGS

The accompanying drawings needed for the description of the embodiments or the related art will be briefly introduced below in conjunction with the accompanying drawings. Apparently, the accompanying drawings in the following description are merely some embodiments of the present disclosure. For those of ordinary skill in the art, other accompanying drawings can also be obtained according to these accompanying drawings without creative effort.
FIG. 1 is a schematic structural diagram of a lifting mechanism disclosed in an embodiment of the present disclosure;
FIG. 2 is a schematic partial structural diagram of a lifting mechanism disclosed in an embodiment of the present disclosure;
FIG. 3 is an exploded view of a lifting mechanism disclosed in an embodiment of the present disclosure;
FIG. 4 and FIG. 5 are schematic structural diagrams of a lifting mechanism disclosed in an embodiment of the present disclosure when located at a first process position;
FIG. 6 is a schematic structural diagram of a lifting mechanism disclosed in an embodiment of the present disclosure when located at a second process position;
FIG. 7 is a schematic structural diagram of a lifting mechanism disclosed in an embodiment of the present disclosure when located at a third process position;
FIG. 8 is a schematic structural diagram of a lift pin of a lifting mechanism disclosed in an embodiment of the present disclosure;
FIG. 9 is a schematic structural diagram of a pin plate of a lifting mechanism disclosed in an embodiment of the present disclosure.

Description of reference numerals:
100-lift pin assembly, 110-pin plate, 111-second positioning part, 112-installation groove, 113-threaded hole, 120-lift pin, 121-first positioning part, 122-installation platform, 122a-installation hole;
200-bellows assembly, 210-bellows shaft, 220-bellows flange;
300-first pneumatic drive source, 310-first body, 311-first vent hole, 312-second vent hole, 320-first slider, 330-first hydraulic limiting column, 340-second hydraulic limiting column;
400-second pneumatic drive source, 410-second body, 411-third vent hole, 412-fourth vent hole, 420-second slider, 430-third hydraulic limiting column, 440-fourth hydraulic limiting column;
500-cushion pad;
600-first connection plate, 610-first plate section, 620-second plate section;
700-second connection plate, 710-third plate section, 720-fourth plate section;
810-first fastener, 820-second fastener, 830-third fastener, 840-fourth fastener, 850-fifth fastener, 860-sixth fastener, 870-seventh fastener, 880-eighth fastener;
900-wafer carrier, 901-chamber body.

### DETAILED DESCRIPTION OF THE EMBODIMENTS

In order to make the objectives, technical solutions, and advantages of the present disclosure clearer, the technical solutions in the embodiments of the present disclosure will be clearly and completely described below in conjunction with the accompanying drawings in the embodiments of the present disclosure. Apparently, the described embodiments are merely a part of the embodiments of the present disclosure, rather than all embodiments. All other embodiments obtained by those of ordinary skill in the art based on the embodiments in the present disclosure without creative effort shall fall within the scope of the present disclosure.

The semiconductor process chamber and the lifting mechanism thereof in the embodiments of the present disclosure will be described in detail below in conjunction with the accompanying drawings through specific embodiments and application scenarios thereof.

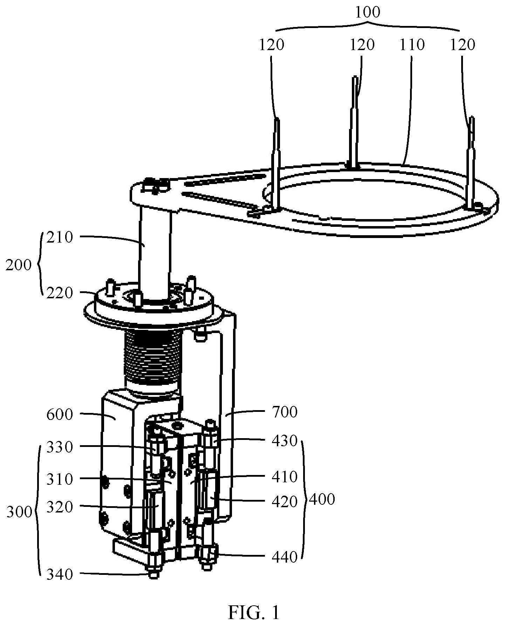

Please refer to FIG. 1 to FIG. 9. An embodiment of the present disclosure provides a lifting mechanism for a semiconductor process chamber. The semiconductor process chamber includes: a chamber body 901 and a wafer carrier 900 disposed in the chamber body 901, and the lifting mechanism includes a lift pin assembly 100, a first drive source, and a second drive source. One end of the lift pin assembly 100 can pass through the wafer carrier 900 and apply a force to a wafer carried on the wafer carrier 900, thereby driving the wafer to move up and down. The wafer carrier 900 here may specifically be a component capable of carrying a wafer, such as an electrostatic chuck or a mechanical chuck; the first drive source is in driving connection with the lift pin assembly 100; and the second drive source is configured to be connected to the chamber body 901, and a telescopic end of the second drive source is connected to the first drive source. During use, the second drive source drives the first drive source to be lifted or lowered among positions of different heights, and the first drive source is configured to drive the lift pin assembly 100 at positions of different heights, such that the lift pin assembly 100 is lifted or lowered among a plurality of process positions.

The second drive source uses the chamber body 901 as an installation foundation, and meanwhile, a driving force output by the second drive source can be transmitted to the first drive source. After such arrangement, the second drive source can drive the first drive source as a whole to be lifted or lowered among positions of different heights, and when the first drive source as a whole is lifted or lowered, the lift pin assembly 100 can be driven to be lifted or lowered. Meanwhile, when the first drive source is located at positions of different heights, the first drive source itself can also drive the lift pin assembly 100 to be lifted or lowered. Thus, it can be seen that, through the combination of various motion forms between the first drive source and the second drive source, the lift pin assembly 100 can be lifted or lowered among a plurality of process positions. At this time, the first drive source and the second drive source can achieve segmented driving of the lift pin assembly 100, thereby causing the lift pin assembly 100 to be lifted or lowered among the plurality of process positions.

In the embodiments of the present disclosure, the second drive source can drive the first drive source to be lifted or lowered among positions of different heights. Therefore, through the combination of the first drive source and the second drive source, the lift pin assembly 100 can be lifted or lowered among a plurality of process positions, thereby adjusting the process position of the wafer. Thus, in the present disclosure, the plurality of process positions of the wafer are assigned to the first drive source and the second drive source, that is, lifting or lowering of the wafer among the plurality of process positions is achieved through the combination of the first drive source and the second drive source, such that the respective positions needed to be reached by the first drive source and the second drive source are reduced, and therefore a condition in which the wafer cannot be lifted or lowered due to gas pressure balance is less likely to occur. Therefore, the technical solutions in the embodiments of the present disclosure can solve the problem that the lifting mechanism has relatively great difficulty in adjusting the process position of the wafer.

In some embodiments, the first drive source and the second drive source are configured to convert fluid pressure into mechanical energy so as to drive the lift pin assembly 100 to be lifted or lowered. In other words, the first drive source and the second drive source are apparatuses driven by fluid pressure, for example, pneumatic drive sources or hydraulic drive sources, where the pneumatic drive sources may adopt pneumatic cylinders, pneumatic sliding tables, or the like; and the hydraulic drive sources may be hydraulic cylinders, hydraulic sliding tables, or the like. In this way, lifting or lowering of the wafer among a plurality of process positions is achieved through the combination of the first drive source and the second drive source, such that the respective positions needed to be reached by the first drive source and the second drive source are reduced, and gas supply methods or liquid supply methods of the first drive source and the second drive source will be simplified, and therefore a condition in which the wafer cannot be lifted or lowered due to pneumatic pressure balance or hydraulic pressure balance is less likely to occur. Therefore, the technical solutions in the embodiments of the present disclosure can solve the problem that the lifting mechanism has relatively great difficulty in adjusting the process position of the wafer.

It should be noted that, in the above embodiments, the first drive source and the second drive source may both adopt pneumatic driving, may both adopt hydraulic driving, or one thereof may adopt pneumatic driving while the other adopts hydraulic driving, which is not limited in the embodiments of the present disclosure.

It should also be noted that, in the above embodiments, the first drive source and the second drive source are configured to convert fluid pressure into mechanical energy so as to drive the lift pin assembly 100 to be lifted or lowered. However, this is likewise not limiting. In some other embodiments not shown in the drawings, one of the first drive source and the second drive source may adopt a fluid-pressure driving mode, or both may adopt other driving modes, which is not limited herein.

The structure and working principle of the present disclosure will be further described below by taking both the first drive source and the second drive source adopting pneumatic driving as an example:
In the present embodiment, the first drive source is a first pneumatic drive source 300, and the second drive source is a second pneumatic drive source 400. Both are connected to the bellows assembly 200 so as to apply a driving force to the bellows assembly 200. The bellows assembly 200 is connected to the lift pin assembly 100, and is configured to transmit a force to the lift pin assembly 100, such that the first pneumatic drive source 300 and the second pneumatic drive source 400 drive the lift pin assembly 100 to be lifted or lowered through the bellows assembly 200. Meanwhile, the bellows assembly 200 is sealingly connected to the chamber body 901 of the semiconductor process chamber, thereby ensuring sealing performance of the chamber body 901 while transmitting the force.

The bellows assembly 200 includes a liftable bellows shaft 210, and the lift pin assembly 100 is connected to the first pneumatic drive source 300 through the bellows shaft 210. In other words, the bellows shaft 210 is respectively connected to the lift pin assembly 100 and the first pneumatic drive source 300, such that the driving force is transmitted to the lift pin assembly 100 through the bellows shaft 210. The second pneumatic drive source 400 is configured to be connected to the chamber body 901 of the semiconductor process chamber, and a telescopic end of the second pneumatic drive source 400 is connected to the first pneumatic drive source 300. That is, the second pneumatic drive source 400 uses the chamber body 901 as an installation foundation, and meanwhile, a driving force output by the second pneumatic drive source 400 can be transmitted to the first pneumatic drive source 300. After such arrangement, the second pneumatic drive source 400 can drive the first pneumatic drive source 300 as a whole to be lifted or lowered, and when the first pneumatic drive source 300 as a whole is lifted or lowered, the bellows shaft 210 can be driven to be lifted or lowered. Meanwhile, when the telescopic end of the first pneumatic drive source 300 extends or retracts, the bellows shaft 210 can also be driven to be lifted or lowered. Thus, through the combination of various motion forms between the first pneumatic drive source 300 and the second pneumatic drive source 400, the lift pin assembly 100 can be lifted or lowered among a plurality of process positions. At this time, the first pneumatic drive source 300 and the second pneumatic drive source 400 can achieve segmented driving of the lift pin assembly 100, thereby causing the lift pin assembly 100 to be lifted or lowered among the plurality of process positions.

In the embodiments of the present disclosure, the second pneumatic drive source 400 can drive the first pneumatic drive source 300 to be lifted or lowered, and the first pneumatic drive source 300 can drive the bellows shaft 210 to be lifted or lowered. Therefore, through the combination of the first pneumatic drive source 300 and the second pneumatic drive source 400, the lift pin assembly 100 can be lifted or lowered among a plurality of process positions, thereby adjusting the process position of the wafer. Thus, in the present disclosure, the plurality of process positions of the wafer are assigned to the first pneumatic drive source 300 and the second pneumatic drive source 400, that is, lifting or lowering of the wafer among the plurality of process positions is achieved through the combination of the first pneumatic drive source 300 and the second pneumatic drive source 400, such that the respective positions needed to be reached by the first pneumatic drive source 300 and the second pneumatic drive source 400 are reduced. In this way, gas supply methods of the first pneumatic drive source 300 and the second pneumatic drive source 400 will be simplified, and therefore a condition in which the wafer cannot be lifted or lowered due to pneumatic pressure balance is less likely to occur. Therefore, the technical solutions in the embodiments of the present disclosure can solve the problem that the lifting mechanism has relatively great difficulty in adjusting the process position of the wafer.

As described above, after driving of the lift pin assembly 100 is achieved through the combination of the first pneumatic drive source 300 and the second pneumatic drive source 400, lifting or lowering movement of the lift pin assembly 100 is less likely to be affected by the pressure environment inside the chamber body 901. Therefore, regardless of whether the chamber body 901 is in an atmospheric state or a vacuum state, the process position of the lift pin assembly 100 can be switched flexibly and accurately. In addition, the first pneumatic drive source 300 and the second pneumatic drive source 400 are relatively independent, therefore parameter adjustment of the first pneumatic drive source 300 and the second pneumatic drive source 400 can also be independently performed. For example, if there is a need to adjust a switching speed of the lift pin assembly 100 among different process positions, related valves (for example, throttle valves mentioned later) of the first pneumatic drive source 300 and the second pneumatic drive source 400 may be independently controlled. Parameter adjustment processes of the first pneumatic drive source 300 and the second pneumatic drive source 400 will not interfere with each other, and therefore difficulties in parameter adjustment of the two are reduced, while parameter adjustment precision is improved.

For example, both the first pneumatic drive source 300 and the second pneumatic drive source 400 may adopt pneumatic cylinders. At this time, a guide structure may additionally be provided so as to guide lifting or lowering of the lift pin assembly 100. In some other embodiments, at least one of the first pneumatic drive source 300 or the second pneumatic drive source 400 is a pneumatic sliding table. Since the pneumatic sliding table itself simultaneously has driving and guiding functions, it is unnecessary to additionally provide a guide structure after the pneumatic sliding table is adopted, and the number of components of the lifting mechanism will be reduced, thereby simplifying the structure and assembly/disassembly procedures of the lifting mechanism. Meanwhile, error accumulation caused by an excessively long transmission path can also be mitigated, thereby improving transmission precision of the lifting mechanism.

In some embodiments, both the first pneumatic drive source 300 and the second pneumatic drive source 400 are pneumatic sliding tables. The first pneumatic drive source 300 includes a first body 310 and a first slider 320. The first slider 320 is slidably connected to the first body 310 along a lifting or lowering direction of the lift pin assembly 100, and the first slider 320 is connected to the bellows shaft 210. The second pneumatic drive source 400 includes a second body 410 and a second slider 420. The second slider 420 is slidably connected to the second body 410 along the lifting or lowering direction of the lift pin assembly 100, the second body 410 is connected to the first body 310, and the second slider 420 is configured to be connected to the chamber body 901. For example, the first body 310 may be provided with a first guide rail extending along the lifting or lowering direction of the lift pin assembly 100, and the first slider 320 is in sliding fit with the first guide rail; and the second body 410 may be provided with a second guide rail extending along the lifting or lowering direction of the lift pin assembly 100, and the second slider 420 is in sliding fit with the second guide rail. Since both the first pneumatic drive source 300 and the second pneumatic drive source 400 are pneumatic sliding tables, the number of components included in the lifting mechanism will be further reduced.

The above first body 310 may be provided with a first vent hole 311 and a second vent hole 312, where the first vent hole 311 and the second vent hole 312 are arranged at intervals along the lifting or lowering direction of the lift pin assembly 100. When gas is supplied to one of the first vent hole 311 and the second vent hole 312, the other may exhaust gas, thereby causing the first slider 320 to slide relative to the first body 310. Similarly, the second body 410 may be provided with a third vent hole 411 and a fourth vent hole 412, where the third vent hole 411 and the fourth vent hole 412 are arranged at intervals along the lifting or lowering direction of the lift pin assembly 100. When gas is supplied to one of the third vent hole 411 and the fourth vent hole 412, the other may exhaust gas, thereby causing the second body 410 to slide relative to the second slider 420. The first vent hole 311, the second vent hole 312, the third vent hole 411, and the fourth vent hole 412 may be arranged at the same side, thereby facilitating arrangement of pipelines. Certainly, the first vent hole 311, the second vent hole 312, the third vent hole 411, and the fourth vent hole 412 may also be arranged at different sides of the first body 310 and the second body 410, which is not limited in the embodiments of the present disclosure.

In order to adjust a lifting or lowering speed of the lift pin assembly 100, a throttle valve may be provided at at least one of the above first vent hole 311, second vent hole 312, third vent hole 411, or fourth vent hole 412. By adjusting the valve opening of the throttle valve, the lifting or lowering speed of the lift pin assembly 100 can be adjusted.

In a further embodiment, since the second slider 420 is fixed relative to the chamber body 901, the second body 410 may slide relative to the second slider 420 and the chamber body 901. During sliding of the second body 410, the first body 310 and the first slider 320 of the first pneumatic drive source 300 will be driven to be lifted or lowered. Meanwhile, the first slider 320 may slide relative to the first body 310. Therefore, as long as at least one of the first body 310, the second body 410, or the first slider 320 moves, the lift pin assembly 100 can be driven to be lifted or lowered. Since the second body 410 is connected to the first body 310, and sizes of the first body 310 and the second body 410 are relatively large, a connection area therebetween is relatively large, and therefore stability of the first body 310, the second body 410, and the first slider 320 during movement is relatively high. Certainly, this is not limiting. In some other embodiments not shown in the drawings, an arrangement mode in which the second slider 420 is connected to the first body 310 and the second body 410 is connected to the chamber body 901 may also be adopted, which is not limited in the present disclosure.

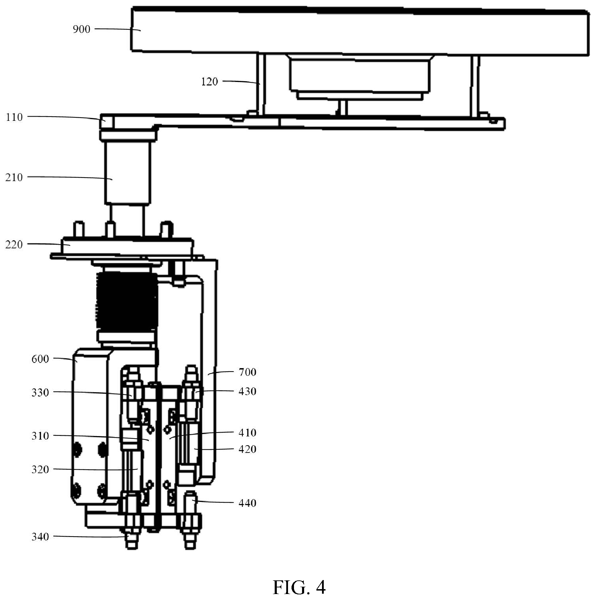

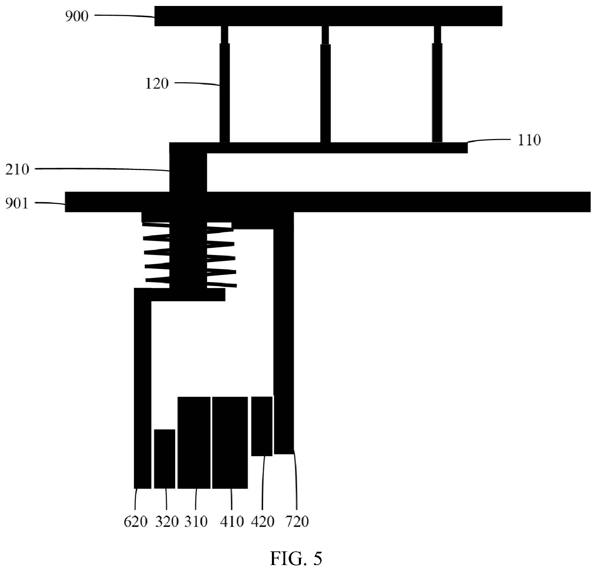

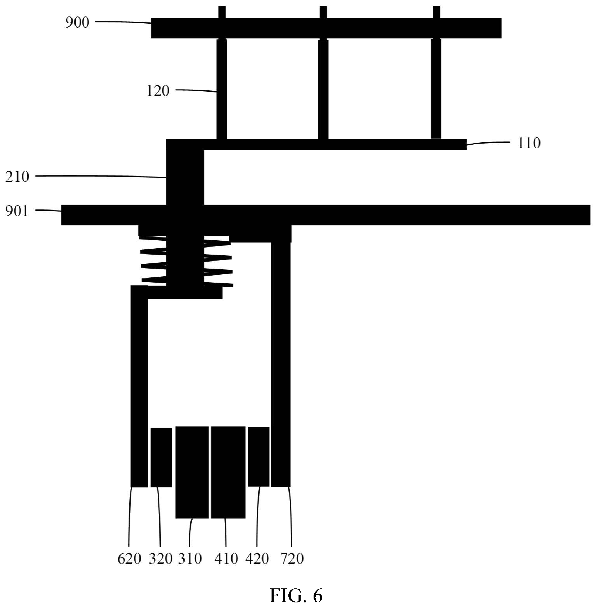

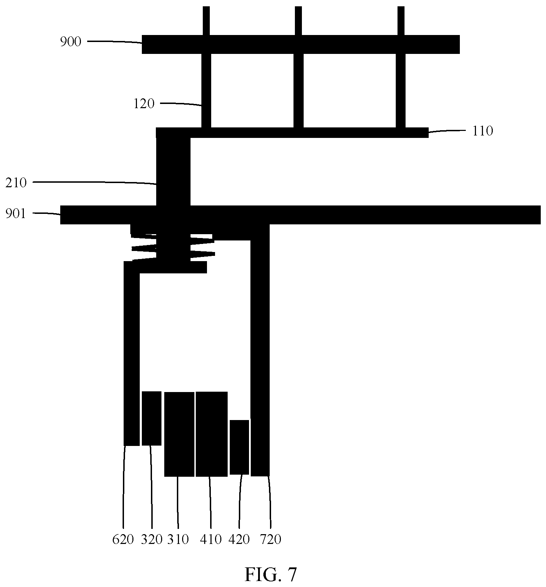

Working positions of the above first body 310, second body 410, and first slider 320 may be flexibly selected, thereby three, four, or even more process positions can be combined. In one embodiment, the first slider 320 has a first upper limit position and a first lower limit position relative to the first body 310, and the second body 410 has a second upper limit position and a second lower limit position relative to the second slider 420. As shown in FIG. 4 and FIG. 5, when the first slider 320 is at the first lower limit position relative to the first body 310, and the second body 410 is at the second lower limit position relative to the second slider 420, the lift pin assembly 100 is at the first process position; as shown in FIG. 6, when the first slider 320 is at the first upper limit position relative to the first body 310, and the second body 410 is at the second lower limit position relative to the second slider 420, the lift pin assembly 100 is at the second process position; and as shown in FIG. 7, when the first slider 320 is at the first upper limit position relative to the first body 310, and the second body 410 is at the second upper limit position relative to the second slider 420, the lift pin assembly 100 is at the third process position. Heights of the first process position, the second process position, and the third process position increase sequentially. For example, the first process position may be a wafer transfer position, while the second process position and the third process position may be positions for executing fabrication processes. For example, the fabrication processes here may be photoresist stripping processes corresponding to different process temperatures.

In the above embodiments, at least three process positions can be combined through upper/lower limit positions of the first slider 320 and upper/lower limit positions of the second body 410. This arrangement solution is sufficient to satisfy process requirements of the wafer. Meanwhile, both the first slider 320 and the second body 410 may be switched between two working positions, such that control of the first slider 320 and the second body 410 is simpler, thereby reducing difficulty in adjusting the wafer process position and improving adjustment precision of the wafer process position.

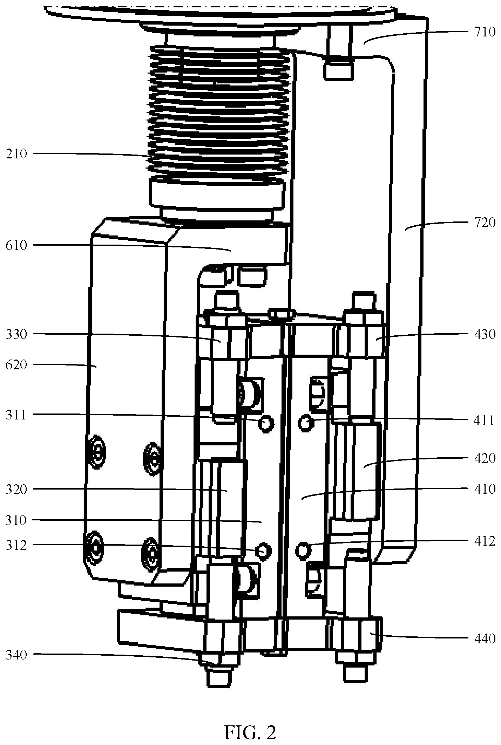

In order to achieve limiting during an extending/retracting process of the above pneumatic sliding table, as shown in FIG. 2, the first pneumatic drive source 300 further includes a first hydraulic limiting column 330 and a second hydraulic limiting column 340. The first hydraulic limiting column 330 and the second hydraulic limiting column 340 are arranged at the first body 310 at intervals along the lifting or lowering direction of the lift pin assembly 100. In other words, the first hydraulic limiting column 330 and the second hydraulic limiting column 340 are both arranged at the first body 310 along the lifting or lowering direction of the lift pin assembly 100, and the first hydraulic limiting column 330 and the second hydraulic limiting column 340 are distributed at intervals along the lifting or lowering direction of the lift pin assembly 100. At least part of the first slider 320 is located between the first hydraulic limiting column 330 and the second hydraulic limiting column 340, and the first slider 320 may respectively in limiting fit with the first hydraulic limiting column 330 and the second hydraulic limiting column 340 along the lifting or lowering direction of the lift pin assembly 100, thereby limiting a relative position between the first slider 320 and the first body 310. Similarly, the second pneumatic drive source 400 further includes a third hydraulic limiting column 430 and a fourth hydraulic limiting column 440. The third hydraulic limiting column 430 and the fourth hydraulic limiting column 440 are arranged at the second body 410 at intervals along the lifting or lowering direction of the lift pin assembly 100. In other words, the third hydraulic limiting column 430 and the fourth hydraulic limiting column 440 are both arranged at the second body 410 along the lifting or lowering direction of the lift pin assembly 100, and the third hydraulic limiting column 430 and the fourth hydraulic limiting column 440 are distributed at intervals along the lifting or lowering direction of the lift pin assembly 100. At least part of the second slider 420 is located between the third hydraulic limiting column 430 and the fourth hydraulic limiting column 440, and the second slider 420 may respectively be in limiting fit with the third hydraulic limiting column 430 and the fourth hydraulic limiting column 440 along the lifting or lowering direction of the lift pin assembly 100, thereby limiting a relative position between the second slider 420 and the second body 410.

Certainly, the first pneumatic drive source 300 and the second pneumatic drive source 400 may also adopt structures such as photoelectric sensors and stoppers to achieve limiting, which is not limited in the embodiments of the present disclosure. Relatively speaking, after the above first hydraulic limiting column 330 and second hydraulic limiting column 340 come into contact with the first slider 320, the first hydraulic limiting column 330 and the second hydraulic limiting column 340 can buffer forces generated during collision, thereby preventing the first body 310 and the first slider 320 from being damaged due to collision. Similarly, after the above third hydraulic limiting column 430 and fourth hydraulic limiting column 440 come into contact with the second slider 420, the third hydraulic limiting column 430 and the fourth hydraulic limiting column 440 can buffer forces generated during collision, thereby preventing the second body 410 and the second slider 420 from being damaged due to collision.

Further, the lifting mechanism includes a cushion pad 500, which is arranged between the first pneumatic drive source 300 and the second pneumatic drive source 400, and the first pneumatic drive source 300 and the second pneumatic drive source 400 are attached through the cushion pad 500.

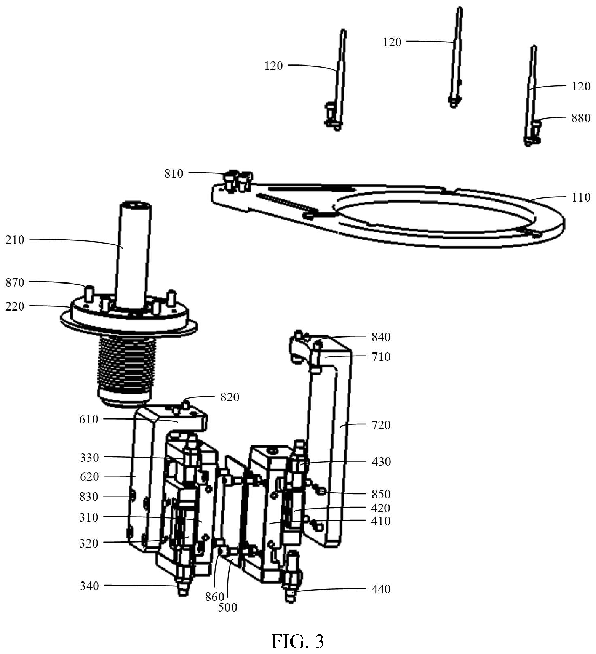

In some embodiments, the first body 310 and the second body 410 are stacked, that is, the first body 310 and the second body 410 are fixedly connected. In other words, as shown in FIG. 2 and FIG. 3, the first body 310 and the second body 410 are adjacently arranged in the horizontal direction, and the cushion pad 500 is arranged between the first body 310 and the second body 410. For example, two opposite surfaces of the cushion pad 500 may respectively fit with the first body 310 and the second body 410, or other components may also be arranged between the cushion pad 500 and the first body 310 and between the cushion pad 500 and the second body 410; and the cushion pad 500 may be made of elastic materials such as rubber. The cushion pad 500 here can provide a buffering effect, thereby absorbing forces between the first body 310 and the second body 410, such that the lift pin assembly 100 is more stable and generates less noise during lifting or lowering. It should be noted that the cushion pad 500 may cover all of the first body 310 and the second body 410, or may cover only part of the first body 310 and the second body 410.

In some embodiments, the first pneumatic drive source 300 may be directly connected to the bellows shaft 210. In the embodiments shown in FIG. 1 and FIG. 2, the lifting mechanism further includes a first connection plate 600. The first connection plate 600 includes a first plate section 610 and a second plate section 620 that are connected and relatively bent to each other. The first plate section 610 is connected to a first end of the bellows shaft 210, and the second plate section 620 is connected to the first pneumatic drive source 300. Specifically, the second plate section 620 is connected to the above-mentioned first slider 320. At this time, the first pneumatic drive source 300 is connected to the bellows shaft 210 through the first connection plate 600. The first connection plate 600 is a bent plate, which can serve as an adaptor, thereby facilitating implementation of connection between the first pneumatic drive source 300 and the bellows shaft 210.

Similarly, in some other embodiments, the second pneumatic drive source 400 may be directly connected to the chamber body 901. In the embodiments shown in FIG. 1 and FIG. 2, the lifting mechanism further includes a second connection plate 700. The second connection plate 700 includes a third plate section 710 and a fourth plate section 720 that are connected and relatively bent to each other. The third plate section 710 is connected to the chamber body 901, and the fourth plate section 720 is connected to the second pneumatic drive source 400. Specifically, the fourth plate section 720 is connected to the above-mentioned second slider 420. At this time, the second pneumatic drive source 400 is connected to the chamber body 901 through the second connection plate 700. The second connection plate 700 is a bent plate, which can serve as an adaptor, thereby facilitating implementation of connection between the second pneumatic drive source 400 and the chamber body 901.

For example, the above first plate section 610, second plate section 620, third plate section 710, and fourth plate section 720 may all be plate structures. The first plate section 610 may be vertically connected to the second plate section 620, and the third plate section 710 may be vertically connected to the fourth plate section 720. The first plate section 610 and the third plate section 710 both extend horizontally, and the second plate section 620 and the fourth plate section 720 both extend vertically. Certainly, this is not limiting. In some other embodiments not shown in the drawings, the first plate section 610 may also be connected to the second plate section 620 at an acute angle or an obtuse angle, and the third plate section 710 may also be connected to the fourth plate section 720 at an acute angle or an obtuse angle, which is not limited in the present disclosure.

As shown in FIG. 6, in order to facilitate implementation of connection between the bellows shaft 210 and the chamber body 901, in the embodiment shown in FIG. 1, the bellows assembly 200 further includes a bellows flange 220. The bellows flange 220 is sleeved outside the bellows shaft 210, the bellows shaft 210 may move up and down relative to the bellows flange 220, and the bellows flange 220 is configured to be connected to the chamber body 901. When the lifting mechanism simultaneously includes the above first connection plate 600 and second connection plate 700, relative positions among the first pneumatic drive source 300, the second pneumatic drive source 400, the first connection plate 600, and the second connection plate 700 may be flexibly selected. For example, the first connection plate 600 and the second connection plate 700 are both located at the same side of the first pneumatic drive source 300 and the second pneumatic drive source 400. In the embodiment shown in FIG. 1, both the first pneumatic drive source 300 and the second pneumatic drive source 400 are located between the second plate section 620 and the fourth plate section 720. At this time, the second plate section 620 and the fourth plate section 720 can protect the first pneumatic drive source 300 and the second pneumatic drive source 400, thereby preventing the first pneumatic drive source 300 and the second pneumatic drive source 400 from being damaged by external forces. In addition, the first connection plate 600 and the second connection plate 700 are respectively located at two sides of the bellows shaft 210, and at least one of the first pneumatic drive source 300 or the second pneumatic drive source 400 is located below the bellows shaft 210, such that the first pneumatic drive source 300, the second pneumatic drive source 400, the first connection plate 600, and the second connection plate 700 are substantially distributed on two sides of the bellows shaft 210, and force bearing of the entire lifting mechanism is more balanced, thereby enabling more stable lifting or lowering.

In order to facilitate assembly and disassembly of the lifting mechanism, in the embodiment shown in FIG. 3, the first plate section 610 may be connected to the bellows shaft 210 through a plurality of first positioning members and a plurality of second fasteners 820; the second plate section 620 may be connected to the first slider 320 through a plurality of third fasteners 830; the third plate section 710 may be connected to the bellows flange 220 through a plurality of second positioning members and a plurality of fourth fasteners 840; the fourth plate section 720 may be connected to the second slider 420 through a plurality of third positioning members and a plurality of fifth fasteners 850; the first body 310 and the second body 410 may be connected through a plurality of sixth fasteners 860; and the bellows flange 220 may be connected to the chamber body 901 through a plurality of seventh fasteners 870. For example, the second fasteners 820, the third fasteners 830, the fourth fasteners 840, the fifth fasteners 850, the sixth fasteners 860, and the seventh fasteners 870 here may all be threaded fasteners, and the first positioning members, the second positioning members, and the third positioning members may all be positioning pins.

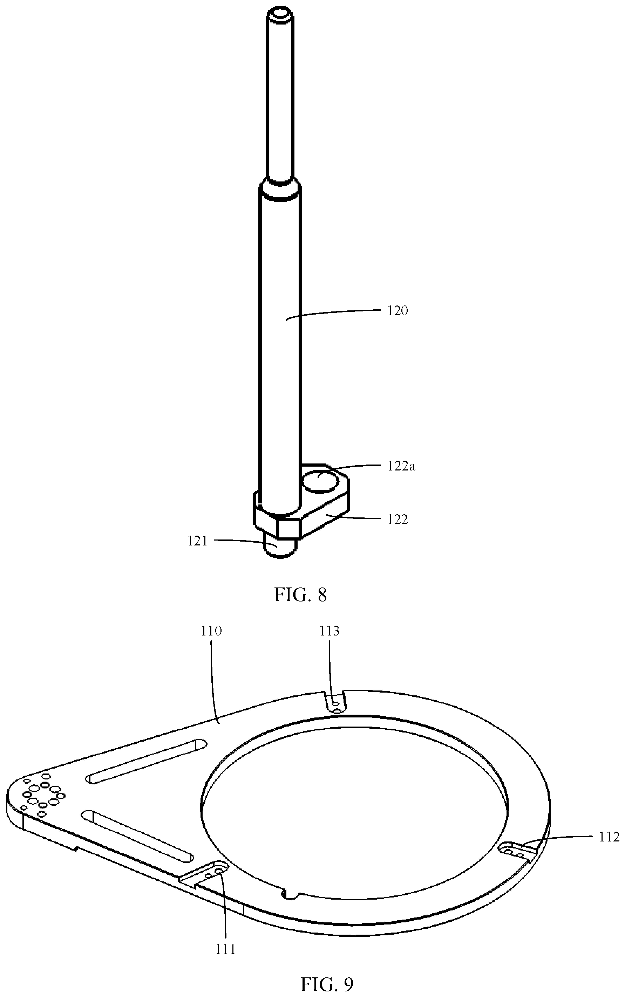

In some embodiments, the lift pin assembly 100 may include a pin plate 110 and three lift pins 120, and the lift pins 120 are arranged at intervals along a circumferential direction of the pin plate 110. The lift pins 120 may simultaneously apply forces to the wafer, thereby supporting the wafer more reliably. A bottom end of the lift pin 120 may be provided with a thread, and the bottom end may be directly in threaded fit with the pin plate 110, thereby achieving connection between the lift pin 120 and the pin plate 110. In the embodiments shown in FIG. 8 and FIG. 9, the bottom end of the lift pin 120 is provided with a first positioning part 121 and an installation platform 122, the pin plate 110 is provided with a second positioning part 111, the first positioning part 121 is in positioning fit with the second positioning part 111, and the installation platform 122 protrudes relative to an outer peripheral surface of the lift pin 120 and is connected to the pin plate 110. When the lift pin 120 is installed, the lift pin 120 is first positioned on the pin plate 110 through positioning fit between the first positioning part 121 and the second positioning part 111, and then the installation platform 122 is connected together with the pin plate 110, so that installation of the lift pin 120 can be achieved. In this embodiment, it is unnecessary to provide a thread on the lift pin 120, and therefore processing of the lift pin 120 is more convenient. Especially for a relatively thin lift pin 120, eliminating the need to provide the thread not only facilitates machining of the lift pin 120, but also avoids damage to the lift pin 120 after repeated assembly and disassembly. Therefore, this arrangement can further prolong the service life of the lift pin 120.

One of the above first positioning part 121 and second positioning part 111 may be a positioning column, and the other may be a positioning hole. The positioning column and the positioning hole may be in insertion fit, thereby achieving positioning fit between the two. When the first positioning part 121 is a positioning column, the first positioning part 121 may protrude toward a side where the pin plate 110 is located relative to the installation platform 122. In addition, the installation platform 122 may be connected to the pin plate 110 through an eighth fastener 880, the eighth fastener 880 may be a threaded fastener, the installation platform 122 may be provided with an installation hole 122a, and one end of the eighth fastener 880 may pass through the installation hole 122a and be in threaded fit with a threaded hole 113 provided on the pin plate 110, thereby achieving connection between the installation platform 122 and the pin plate 110.

In some embodiments, an upper surface of the pin plate 110 may be a plane. In the embodiment shown in FIG. 9, the pin plate 110 is further provided with an installation groove 112, a bottom wall of the installation groove 112 is provided with the second positioning part 111, and at least part of the installation platform 122 is located in the installation groove 112. At this time, during installation of the lift pin 120, the installation groove 112 has a pre-positioning function, and therefore, during assembly, at least part of the installation platform 122 may first be placed in the installation groove 112, so that the lift pin 120 can be placed at a target position more quickly, and installation of the lift pin 120 can be completed more quickly. Meanwhile, after installation of the lift pin 120 is completed, the installation groove 112 can perform auxiliary limiting on the installation platform 122, further preventing the lift pin 120 from moving relative to the pin plate 110, such that position precision of the lift pin 120 is higher. Further, the installation groove 112 may be provided with a cutout, so that the installation groove 112 extends to an edge of the pin plate 110. After such arrangement, the installation platform 122 of the lift pin 120 may horizontally slide into the installation groove 112 through the cutout, thereby facilitating installation of the lift pin 120.

It should be noted that the number of the lift pins 120 is at least two. Only a part of the lift pins 120 may adopt the above structure, or all of the lift pins 120 may adopt the above structure. At this time, the second positioning parts 111 and the installation grooves 112 on the pin plate 110 may correspond to the lift pins 120 in a one-to-one manner.

As described above, the lift pin assembly 100 may include the pin plate 110 and three lift pins 120, and the lift pins 120 are arranged at intervals along the circumferential direction of the pin plate 110. The pin plate 110 and the bellows shaft 210 may be connected through an additionally provided component, or an end surface of a second end of the bellows shaft 210 fits with a lower surface of the pin plate 110, and the second end of the bellows shaft 210 is connected to the pin plate 110 through a first fastener 810. In this embodiment, the pin plate 110 is directly connected to the bellows shaft 210, thereby reducing the number of components included in the lifting mechanism, so as to further simplify the structure and assembly/disassembly procedures of the lifting mechanism and further mitigate error accumulation caused by an excessively long transmission path, thereby improving transmission precision of the lifting mechanism. Optionally, the number of the first fasteners 810 may be one or more, and the first fastener 810 may specifically be a threaded fastener.

It should be noted that, in the above embodiments, the number of the lift pins 120 is three, but this is not limiting. In some other embodiments not shown in the drawings, the number of the lift pins 120 may also be two, and the two lift pins 120 are oppositely arranged. A support part may be provided at the top of each lift pin 120 to enlarge a support surface of the lift pin 120 and ensure stability of supporting the wafer. In some other embodiments not shown in the drawings, the number of the lift pins 120 may also be four, five, or the like, which is not limited in the present disclosure.

An embodiment of the present disclosure further provides a semiconductor process chamber, which includes a chamber body 901 and the lifting mechanism according to any of the above embodiments, and the lifting mechanism is connected to the chamber body 901.

The above embodiments of the present disclosure focus on describing differences between the embodiments. Different optimized features between the embodiments may be combined to form better embodiments as long as they are not contradictory. For conciseness of description, details are not described herein again.

The above descriptions are merely embodiments of the present disclosure and are not intended to limit the present disclosure. For those skilled in the art, the present disclosure may have various modifications and variations. Any modification, equivalent replacement, improvement, or the like made within the spirit and principle of the present disclosure shall fall within the scope of the claims of the present disclosure.

## Claims

1. A lifting mechanism, for a semiconductor process chamber, comprising:
a lift pin assembly;
a first drive source, in driving connection with the lift pin assembly;
a second drive source, configured to be connected to a chamber body of the semiconductor process chamber, and a telescopic end of the second drive source is connected to the first drive source;
wherein the second drive source drives the first drive source to be lifted or lowered among positions of different heights, and the first drive source is configured to drive the lift pin assembly at positions of different heights, such that the lift pin assembly is lifted or lowered among a plurality of process positions.

2. The lifting mechanism according to claim 1, wherein the lifting mechanism further includes: a bellows assembly, the bellows including:
a bellows shaft connected between the first drive source and the lift pin assembly, wherein the first drive source drives the lift pin assembly to be lifted or lowered by driving the bellows shaft.

3. The lifting mechanism according to claim 1, wherein:
the first drive source and/or the second drive source is a sliding table.

4. The lifting mechanism according to claim 2, wherein the first drive source includes:
a first body connected to the telescopic end of the second drive source;
a first slider slidably connected to the first body along a lifting or lowering direction of the lift pin assembly, the first slider being connected to the bellows shaft.

5. The lifting mechanism according to claim 4, wherein the first drive source further includes:
a first hydraulic limiting column arranged at the first body;
a second hydraulic limiting column arranged at the first body and spaced apart from the first hydraulic limiting column in the lifting or lowering direction, at least part of the first slider being located between the first hydraulic limiting column and the second hydraulic limiting column, and the first slider being configured to respectively be in limiting engagement with the first hydraulic limiting column and the second hydraulic limiting column.

6. The lifting mechanism according to claim 2, wherein the lifting mechanism further includes:
a first connection plate including a first plate section and a second plate section that are connected and relatively bent to each other, the first plate section being connected to one end of the bellows shaft, and the second plate section being connected to the first drive source, such that the first drive source drives the bellows shaft through the first connection plate; or
a second connection plate including a third plate section and a fourth plate section that are connected and relatively bent to each other, the third plate section being connected to the chamber body, and the fourth plate section being connected to the second drive source.

7. The lifting mechanism according to claim 2, wherein:
the bellows assembly further includes: a bellows flange sleeved outside the bellows shaft, the bellows flange being configured to be connected to the chamber body;
the lifting mechanism further includes:
a first connection plate including a first plate section and a second plate section that are connected and relatively bent to each other, the first plate section being connected to one end of the bellows shaft, and the second plate section being connected to the first drive source, such that the first drive source drives the bellows shaft through the first connection plate;
a second connection plate including a third plate section and a fourth plate section that are connected and relatively bent to each other, the third plate section being connected to the bellows flange, the fourth plate section being connected to the second drive source, and the first drive source and the second drive source being both located between the second plate section and the fourth plate section.

8. The lifting mechanism according to claim 1, wherein the second drive source includes:
a second body connected to the first drive source;
a second slider slidably connected to the second body along a lifting or lowering direction of the lift pin assembly, the second slider being configured to be connected to the chamber body.

9. The lifting mechanism according to claim 8, wherein the second drive source further includes:
a third hydraulic limiting column arranged at the second body;
a fourth hydraulic limiting column arranged at the second body and spaced apart from the third hydraulic limiting column in the lifting or lowering direction, at least part of the second slider being located between the third hydraulic limiting column and the fourth hydraulic limiting column, and the second slider being configured to respectively be in limiting engagement with the third hydraulic limiting column and the fourth hydraulic limiting column.

10. The lifting mechanism according to claim 2, wherein the lifting mechanism further includes:
a cushion pad arranged between the first drive source and the second drive source, wherein the first drive source and the second drive source are attached through the cushion pad.

11. The lifting mechanism according to claim 1, wherein the lift pin assembly includes:
a pin plate provided with a second positioning part;
at least two lift pins, all the lift pins are arranged at intervals along a circumferential direction of the pin plate, a bottom end of each lift pin being provided with a first positioning part and an installation platform, the first positioning part being in positioning fit with the second positioning part, and the installation platform being connected to the pin plate.

12. The lifting mechanism according to claim 11, wherein:
the pin plate is further provided with an installation groove, a bottom wall of the installation groove being provided with the second positioning part, and at least part of the installation platform being located in the installation groove.

13. The lifting mechanism according to claim 2, wherein the lift pin assembly includes:
a pin plate connected to the bellows shaft, a lower surface of the pin plate fitting with an end surface of one end of the bellows shaft away from the first drive source;
at least two lift pins, all the lift pins are arranged at intervals along a circumferential direction of the pin plate.

14. The lifting mechanism according to claim 1, wherein:
the first drive source and/or the second drive source is configured to convert fluid pressure into mechanical energy so as to drive the lift pin assembly to be lifted or lowered.

15. A semiconductor process chamber, comprising a chamber body and the lifting mechanism according to any one of claims 1 to 14, wherein the lifting mechanism is connected to the chamber body.
